(19) Europäisches Patentamt
European Patent Office
Office européen des brevets

(11) **EP 4 708 331 A2**

(12) **EUROPEAN PATENT APPLICATION**

(43) Date of publication:
**11.03.2026 Bulletin 2026/11**

(21) Application number: **26152147.0**

(22) Date of filing: **14.11.2024**

(51) International Patent Classification (IPC):
**G21K 1/06** (2006.01)

(52) Cooperative Patent Classification (CPC):
**G03F 1/24; G03F 1/52; G21K 1/062**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **28.11.2023 JP 2023200681**
**28.05.2024 JP 2024086360**
**24.10.2024 JP 2024187136**

(62) Document number(s) of the earlier application(s) in accordance with Art. 76 EPC:
**24212908.8 / 4 564 093**

(71) Applicant: **Shin-Etsu Chemical Co., Ltd.**
**Chiyoda-ku**
**Tokyo 100-0005 (JP)**

(72) Inventors:
• **OGOSE, Taiga**
**Joetsu-shi 9428601 (JP)**

• **KANEKO, Hideo**
**Joetsu-shi 9428601 (JP)**
• **INAZUKI, Yukio**
**Joetsu-shi 9428601 (JP)**
• **KOSAKA, Takuro**
**Joetsu-shi 9428601 (JP)**

(74) Representative: **Mewburn Ellis LLP**
**Aurora Building**
**Counterslip**
**Bristol BS1 6BX (GB)**

Remarks:
This application was filed on 15.01.2026 as a divisional application to the application mentioned under INID code 62.

(54) **REFLECTIVE MASK BLANK AND MANUFACTURING METHOD THEREOF**

(57) A reflective mask blank including a substrate, a multilayer reflection film that is formed on one main surface of the substrate and reflects exposure light is provided. The multilayer reflection film has a periodically laminated structure in which repeating units are multiply stacked, the repeating unit includes one each of a high refractive index layer, a low refractive index layer, and a medium refractive index layer having a refractive index lower than a refractive index of the high refractive index layer and higher than a refractive index of the low refractive index layer, and in the repeating unit, the high refractive index layer and the medium refractive index layer are disposed at the substrate side and the side remote from the substrate, respectively, with respect to the low refractive index layer.

**FIG.1**

EP 4 708 331 A2

**Description**

TECHNICAL FIELD

The present invention relates to a reflective mask blank which is a material for a reflective mask used in manufacturing semiconductor devices such as LSIs, and a manufacturing method thereof.

BACKGROUND

In manufacturing processes of semiconductor devices, a photolithography technique in which a circuit pattern formed on a transfer mask is transferred onto a semiconductor substrate (a semiconductor wafer) through a reduction projection optical system with irradiating exposure light to the transfer mask is repeatedly used. Conventionally, a mainstream wavelength of the exposure light has been 193 nm by argon fluoride (ArF) excimer laser light. A pattern with dimensions smaller than the exposure wavelength has finally been formed by adopting a process called multi-patterning in which exposure processes and processing processes are combined multiple times.

However, since it is necessary to form further fine patterns under continuous miniaturization of device patterns, an extreme ultraviolet lithography technique utilizing, as exposure light, extreme ultraviolet (hereafter refers to as "EUV") light having a shorter wavelength than the wavelength of ArF excimer laser light has been used. The EUV light is light having a wavelength of about 0.2 to 100 nm, in particular, light having a wavelength of around 13.5 nm. The EUV light has a very low transparency to a substance and cannot be utilized for a conventional transmissive projection optical system or a mask, thus, reflection type optical elemental devices are applied. Therefore, a reflective mask has been also proposed as a mask for pattern transfer.

In a common reflective mask, a multilayer reflection film that reflects EUV light is formed on a substrate, and a patterned absorber film that absorbs EUV light is formed on the multilayer reflection film. On the other hand, generally, a material (including also a material in which a resist film is formed) before patterning the absorber film is called a reflective mask blank, and is used as a material for the reflective mask. The reflective mask blank has a basic structure that includes a substrate, and a multilayer reflection film that is formed on the substrate and reflects EUV light, and in many cases, also includes an absorber film that is formed on the multilayer reflection film and absorbs EUV light.

Citation List

Patent Document 1: JP-A 2007-109971

SUMMARY OF THE INVENTION

In EUV lithography, EUV light, which is exposure light, is incident on a reflective mask at an angle, and is incident mainly at an angle of 6 degrees with respect to the normal to the main surface of the reflective mask. A part of the exposure light incident at an angle is blocked by the sidewall of an absorber pattern, resulting in so-called 3D effect (three-dimensional effect, or shadowing effect). The 3D effect causes positional and dimensional deviations of a transferred pattern. Thus, it is preferable to reduce the 3D effect for minimizing the absorber pattern. The 3D effect can be reduced by a thinner absorber pattern. Therefore, it is desirable to reduce the thickness of the absorber pattern.

On the other hand, in addition to the thickness of the absorber pattern, the 3D effect also changes depending on a structure of the multilayer reflection film. The reflection of EUV light, which is exposure light, by the multilayer reflection film is caused by overlapping of reflections occurred at respective interfaces of layers inside the multilayer reflection film. However, when the reflections at positions deeper from the surface of the multilayer reflection film mainly contribute in the reflection of the exposure light by the multilayer reflection film, the 3D effect increases. Therefore, to reduce the 3D effect, it is advantageous for the multilayer reflection film to relatively increase contribution of reflections at positions closer to the surface.

Generally, the multilayer reflection film has a periodically laminated structure in which low refractive index layers and high refractive index layers are alternately laminated, and a multilayer reflection film (a Mo/Si multilayer reflection film) in which molybdenum (Mo) layers and silicon (Si) layers are alternately laminated, for example 40 cycles is known as a film that efficiently reflects EUV light, and is currently used as a mainstream multilayer reflection film in an EUV mask blank.

The present invention has been made to solve the above problems, and an object of the present invention is to provide a reflective mask blank including a multilayer reflection film that has reduced 3D effect and a high reflectance, and to provide a manufacturing method of the reflective mask blank.

Ruthenium (Ru) is a material having a lower refractive index and a higher extinction coefficient with respect to EUV light having a wavelength of 13.5 nm, which is the exposure light, compared to molybdenum (Mo). Therefore, a low refractive index layer of ruthenium (Ru) has a higher reflection coefficient compared to a low refractive index layer of molybdenum (Mo) in the case of having an ideal interface (an interface without interdiffusion or roughness) with a high refractive index layer using silicon (Si) and others.

Therefore, in a multilayer reflection film having fewer layers, a multilayer reflection film using ruthenium (Ru) as a low refractive index layer (a Ru/Si multilayer reflection film) provides a higher reflectance compared to a Mo/Si multilayer reflection film. Further, in comparing at the same number of the layers, contribution of reflections at positions closer to the surface of the Ru/Si multilayer reflection film is relatively large, and the Ru/Si multilayer reflection film is advantageous in terms of reducing the 3D effect. On the other hand, since ruthenium (Ru) has a larger extinction coefficient, when the number of layers in the multilayer reflection film is increased, the Ru/Si multilayer reflection film results in a lower reflectance compared to the Mo/Si multilayer reflection film.

The inventors have made earnest studies to solve the above problems. As a result, the inventors found a multilayer reflection film, which is a basic component in a reflective mask blank and a reflective mask, including a high refractive index layer, a low refractive index layer and a medium refractive index layer, particularly, further including an intermediate layer with the high refractive index layer, the low refractive index layer and the medium refractive index layer, and found a multilayer reflection film having a periodically laminated structure including multiply stacked repeating units in which respective layers are laminated in a specific order. Further, the inventors found that the multilayer reflection film has reduced 3D effect and a high reflectance.

In one aspect, the invention provides a reflective mask blank including a substrate, a multilayer reflection film that is formed on one main surface of the substrate and reflects exposure light, wherein

the multilayer reflection film has a periodically laminated structure in which repeating units are multiply stacked, the repeating unit includes one each of a high refractive index layer, a low refractive index layer, and a medium refractive index layer having a refractive index lower than a refractive index of the high refractive index layer and higher than a refractive index of the low refractive index layer, and
in the repeating unit, the high refractive index layer and the medium refractive index layer are disposed at the substrate side and the side remote from the substrate, respectively, with respect to the low refractive index layer.

Preferably, with respect to a wavelength of the exposure light, the high refractive index layer, the low refractive index layer, and the medium refractive index layer in the repeating unit satisfy all of the following expressions (1) and (2):

$$k_H < k_L \qquad\qquad (1),$$

and

$$k_M < ((k_H - k_L)/(n_H - n_L)) \times (n_M - n_L) + k_L \qquad\qquad (2),$$

wherein $n_H$, $n_L$ and $n_M$ represent refractive indexes of the high refractive index layer, the low refractive index layer, and the medium refractive index layer, respectively, and $k_H$, $k_L$ and $k_M$ represent extinction coefficients of the high refractive index layer, the low refractive index layer, and the medium refractive index layer, respectively.

Preferably, the high refractive index layer contains silicon (Si), the low refractive index layer contains ruthenium (Ru), and the medium refractive index layer contains at least one selected from the group consisting of molybdenum (Mo), niobium (Nb) and zirconium (Zr).

Preferably, the multilayer reflection film includes an intermediate layer at one or more positions selected from the group consisting of a position intervening between the high refractive index layer and the low refractive index layer, a position intervening between the low refractive index layer and the medium refractive index layer, and a position intervening between the medium refractive index layer and the high refractive index layer.

Preferably, the multilayer reflection film includes the intermediate layer intervening between the high refractive index layer and the low refractive index layer.

Preferably, with respect to a wavelength of the exposure light, the high refractive index layer, the intermediate layer intervening between the high refractive index layer and the low refractive index layer, the low refractive index layer, and the medium refractive index layer in the repeating unit satisfy all of the following expressions (1), (2) and (3):

$$k_H < k_L \qquad\qquad (1),$$

$$k_M < ((k_H - k_L)/(n_H - n_L)) \times (n_M - n_L) + k_L \qquad\qquad (2),$$

and

$$k_I > ((k_H - k_L)/(n_H - n_L)) \times (n_I - n_L) + k_L \qquad (3),$$

wherein $n_H$, $n_I$, $n_L$ and $n_M$ represent refractive indexes of the high refractive index layer, the intermediate layer intervening between the high refractive index layer and the low refractive index layer, the low refractive index layer, and the medium refractive index layer, respectively, and $k_H$, $k_I$, $k_L$ and $k_M$ represent extinction coefficients of the high refractive index layer, the intermediate layer intervening between the high refractive index layer and the low refractive index layer, the low refractive index layer, and the medium refractive index layer, respectively.

Preferably, the repeating unit consists of one each of the high refractive index layer, the intermediate layer, the low refractive index layer, and the medium refractive index layer, and in the repeating unit, the high refractive index layer, the intermediate layer, the low refractive index layer, and the medium refractive index layer are arranged in this order from the substrate side.

Preferably, the multilayer reflection film consists of the periodically laminated structure, and another high refractive index layer disposed at the side remotest from the substrate.

Preferably, the high refractive index layer contains silicon (Si), the intermediate layer contains either or both of silicon nitride (SiN) and tantalum nitride (TaN), the low refractive index layer contains ruthenium (Ru), and the medium refractive index layer contains at least one selected from the group consisting of molybdenum (Mo), niobium (Nb) and zirconium (Zr).

Preferably, the high refractive index layer consists of silicon (Si), the intermediate layer consists of either or both of silicon nitride (SiN) and tantalum nitride (TaN), the low refractive index layer consists of ruthenium (Ru), and the medium refractive index layer consists of at least one selected from the group consisting of molybdenum (Mo), niobium (Nb) and zirconium (Zr).

Preferably, the high refractive index layer has a thickness of not less than 2.5 nm and not more than 5.5 nm, the intermediate layer has a thickness of not less than 0.2 nm and not more than 1 nm, the low refractive index layer has a thickness of not less than 0.5 nm and not more than 4 nm, and the medium refractive index layer has a thickness of not less than 0.5 nm and not more than 4 nm.

In another aspect, the invention provides a manufacturing method of the reflective mask blank, including the step of forming the multilayer reflection film by sputtering using a sputtering apparatus on which three or more types of targets can be simultaneously mounted in its chamber, and sequentially discharging the three or more types of targets.

## ADVANTAGEOUS EFFECTS

The reflective mask blank of the invention has a multilayer reflection film that has reduced 3D effect compared to conventional multilayer reflection films, and from the reflective mask blank of the invention, a reflective mask that has a high reflectance can be obtained.

## BRIEF DESCRIPTION OF THE DRAWINGS

FIG. 1 is a cross-sectional view illustrating an example of a reflective mask blank of the invention.

FIG. 2 is a cross-sectional view illustrating an example of a multilayer reflection film of the invention.

FIG. 3 is a cross-sectional view illustrating another example of a multilayer reflection film of the invention.

FIG. 4 is a cross-sectional view illustrating another example of a reflective mask blank of the invention.

## FURTHER EXPLANATIONS; OPTIONS AND PREFERENCES

A reflective mask blank of the invention includes a substrate, a multilayer reflection film that is formed on one main surface (front-side surface) of the substrate and reflects exposure light.

The reflective mask blank of the invention is suitable for a material (an EUV mask blank) for a reflective mask (an EUV mask) used in EUV lithography utilizing EUV light as exposure light. The EUV light used as exposure light in the EUV lithography has a wavelength of 13 to 14 nm, commonly about 13.5 nm.

For use of EUV light exposure, the substrate preferably has low thermal expansion property. For example, the substrate is preferably composed of a material having a coefficient of thermal expansion within $\pm 2 \times 10^{-8}/°C$, preferably within $\pm 5 \times 10^{-9}/°C$. As the material, a titania-doped quartz glass ($SiO_2$-$TiO_2$-based glass) is exemplified. Further, a substrate having a sufficiently flatted surface is preferably used. The main surface of the substrate has a surface roughness, as an RMS value, of preferably not more than 0.5 nm, more preferably not more than 0.2 nm. Such a surface roughness can be obtained by polishing of the substrate, or others. The substrate preferably has dimensions of 152 mm-square in main surface and 6.35 mm in thickness. The substrate having the dimensions is so-called a 6025 substrate, which has dimensions of 6 inches-square in the main surface and 0.25 inches in the thickness.

The multilayer reflection film is a film that reflects EUV light, which is exposure light, in the reflective mask. The multilayer reflection film may be formed in contact with one main surface of the substrate, and an underlayer film may be formed between the substrate and the multilayer reflection film. The multilayer reflection film has a reflectance of preferably not less than 60%, more preferably not less than 62%, even more preferably not less than 65%, with respect to EUV light (wavelength: 13.5 nm), which is exposure light, at an incident angle of 6 degrees to the normal of the main surface of the multilayer reflection film.

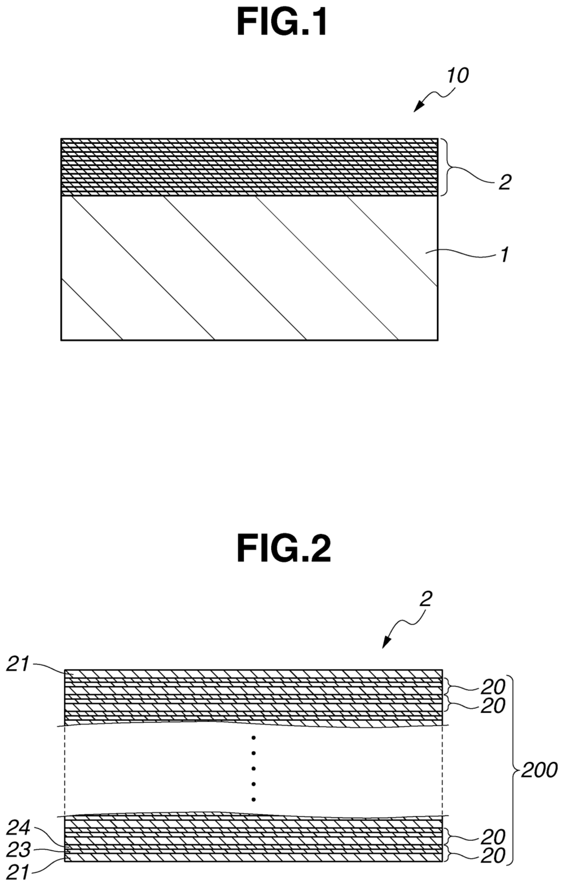

FIG. 1 is a cross-sectional view illustrating an example of a reflective mask blank of the invention. This reflective mask blank 10 includes a substrate 1, and on the substrate 1, a multilayer reflection film 2 that is formed in contact with the substrate 1.

The multilayer reflection film of the invention has a periodically laminated structure in which repeating units are multiply stacked, and the repeating unit includes one each of a high refractive index layer, a low refractive index layer, and a medium refractive index layer. The periodically laminated structure has a cycle number (a number of the repeating units) of preferably not less than 10 cycles, more preferably not less than 20 cycles, and not more than 50 cycles, more preferably not more than 40 cycles, even more preferably not more than 30 cycles.

The high refractive index layer is a layer that is composed of a material having a relatively high refractive index with respect to EUV light, which is exposure light, and the low refractive index layer is a layer that is composed of a material having a relatively low refractive index with respect to EUV light, which is exposure light. On the other hand, the medium refractive index layer is a layer that is composed of a material having a refractive index lower than the refractive index of the high refractive index layer and higher than the refractive index of the low refractive index layer. Accordingly, when refractive indexes of the high refractive index layer, the low refractive index layer, and the medium refractive index layer (the refractive index of the material constituting the high refractive index layer, the refractive index of the material constituting the low refractive index layer, and the refractive index of the material constituting the medium refractive index layer) are $n_H$, $n_L$ and $n_M$, respectively, the refractive indexes in the repeating unit satisfy the expression: $n_H > n_M > n_L$.

Further, from the viewpoint of obtaining a high reflectance, with respect to a wavelength of the exposure light, the high refractive index layer, the low refractive index layer, and the medium refractive index layer in the repeating unit preferably satisfy all of the following expressions (1) and (2):

$$k_H < k_L \qquad\qquad\qquad (1),$$

and

$$k_M < ((k_H - k_L)/(n_H - n_L)) \times (n_M - n_L) + k_L \qquad\qquad (2),$$

wherein $n_H$, $n_L$ and $n_M$ represent refractive indexes of the high refractive index layer, the low refractive index layer, and the medium refractive index layer, respectively, and $k_H$, $k_L$ and $k_M$ represent extinction coefficients of the high refractive index layer, the low refractive index layer, and the medium refractive index layer, respectively.

With respect to arrangements of the high refractive index layer, the low refractive index layer, and the medium refractive index layer in the repeating unit, the high refractive index layer is preferably disposed at the substrate side with respect to the low refractive index layer, and the medium refractive index layer is preferably disposed at the side remote from the substrate with respect to the low refractive index layer. Particularly, a high reflectance can be obtained by an arrangement of the medium refractive index layer disposed at the side remote from the substrate with respect to the low refractive index layer, further, a higher reflectance can be obtained by an arrangement of the high refractive index layer disposed at the substrate side with respect to the low refractive index layer. Therefore, it is preferably that the high refractive index layer, the low refractive index layer, and the medium refractive index layer are arranged in this manner.

The multilayer reflection film of the invention may consist of the periodically laminated structure in which repeating units are multiply stacked, and preferably, a high refractive index layer is formed in the multilayer reflection film as another layer disposed at the side remotest from the substrate. Further, a layer for protecting the periodically laminated structure (a protection layer) may be formed in the multilayer reflection film as another layer disposed at the side remotest from the substrate. In the case of forming the other layer, the multilayer reflection film may consist of the periodically laminated structure in which repeating units are multiply stacked, and the other layer (the high refractive index layer, the protection layer or others) formed at the side remotest from the substrate. A protection film or an absorber layer described later is formed on the repeating unit at the side remotest from the substrate in the multilayer reflection film when the other layer is not formed, or on the other layer when the other layer is formed at the side remotest from the substrate in the multilayer reflection film.

In the multilayer reflection film, an intermediate layer may be formed at a position between the layers of the high refractive index layer, the low refractive index layer, and the medium refractive index layer to prevent formation of a layer (a reaction layer, an interdiffusion layer) that may be formed at the interface portion of the layers during formation of the multilayer reflection film or by heat treatment after the formation of the multilayer reflection film. The multilayer reflection film of the invention preferably includes an intermediate layer at one or more positions between the high refractive index layer and the low refractive index layer, at one or more positions between the low refractive index layer and the medium refractive index layer, or at one or more positions between the medium refractive index layer and the high refractive index layer.

The intermediate layer is preferably included at either or two or more of positions selected from the group consisting of all positions between the high refractive index layer and the low refractive index layer, all positions between the low refractive index layer and the medium refractive index layer, and all positions between the medium refractive index layer and the high refractive index layer. Particularly, the intermediate layer is preferably included at the position between the high refractive index layer and the low refractive index layer. In this case, the position between the high refractive index layer and the low refractive index layer, and the position between the low refractive index layer and the medium refractive index layer are located in the same repeating unit, and the position between the medium refractive index layer and the high refractive index layer is located between adjacent repeating units.

In the case that the low refractive index layer, particularly, a low refractive index layer containing ruthenium (Ru) is formed in contact with the high refractive index layer, particularly, a high refractive index layer containing silicon (Si) by sputtering, a reaction layer containing silicon (Si) and ruthenium (Ru) tends to be formed at the interface portion between the high refractive index layer containing silicon (Si) and the low refractive index layer containing ruthenium (Ru) by energy derived from sputtering particles such as ruthenium (Ru) atoms and clusters that are sputtered from a target. The formation of the reaction layer causes reduction of the reflectance of the multilayer reflection film. Therefore, the intermediate layer is more preferably included at one or more positions, particularly all positions between the high refractive index layer and the low refractive index layer, the formation of the reaction layer is effectively prevented by forming the intermediate layer.

Among the position between the high refractive index layer and the low refractive index layer, the position between the low refractive index layer and the medium refractive index layer, and the position between the medium refractive index layer and the high refractive index layer, the intermediate layer is preferably formed at the position between the high refractive index layer and the low refractive index layer from the viewpoint of obtaining a high reflectance.

In the case that the multilayer reflection film of the invention includes the intermediate layer at the position between the high refractive index layer and the low refractive index layer, with respect to a wavelength of the exposure light, the high refractive index layer, the intermediate layer intervening between the high refractive index layer and the low refractive index layer, and the low refractive index layer in the repeating unit preferably satisfy the following expression (3):

$$k_I > ((k_H - k_L)/(n_H - n_L)) \times (n_I - n_L) + k_L \qquad (3),$$

wherein $n_H$, $n_I$ and $n_L$ represent refractive indexes of the high refractive index layer, the intermediate layer intervening between the high refractive index layer and the low refractive index layer, and the low refractive index layer, respectively, and $k_H$, $k_I$ and $k_L$ represent extinction coefficients of the high refractive index layer, the intermediate layer intervening between the high refractive index layer and the low refractive index layer, and the low refractive index layer, respectively.

Also, in the case that the multilayer reflection film of the invention includes the intermediate layer, with respect to a wavelength of the exposure light, the high refractive index layer, the low refractive index layer, and the medium refractive index layer in the repeating unit preferably satisfy all of the above expressions (1) and (2).

Examples of the repeating units include a repeating unit that consists of three layers of one high refractive index layer, one low refractive index layer, and one medium refractive index layer. In this case, in the repeating unit, respective layers are arranged in the order of the high refractive index layer, the low refractive index layer, and the medium refractive index layer from the substate side.

FIG. 2 is a cross-sectional view illustrating an example of a multilayer reflection film of the invention. This multilayer reflection film 2 include a periodically laminated structure 200 in which repeating units 20 consisting of, from the substrate side (bottom side in the figure), a high refractive index layer 21, a low refractive index layer 23, and a medium refractive index layer 24 are multiply stacked. At the side remote from the substrate of the periodically laminated structure 200 (the uppermost portion in the figure), a high refractive index layer 21, as a layer remotest from the substrate in the multilayer reflection film 2, is formed in contact with the periodically laminated structure 200.

Further, examples the repeating units include a repeating unit that consists of four, five or six layers of one high refractive index layer, one low refractive index layer, one medium refractive index layer, and one, two or three intermediate layers. As such, the repeating unit preferably consists of one each of the high refractive index layer, the intermediate layer, the low refractive index layer, and the medium refractive index layer, and in the repeating unit, respective layers are preferably arranged in the order of the high refractive index layer, the intermediate layer, the low refractive index layer and the medium refractive index layer from the substate side.

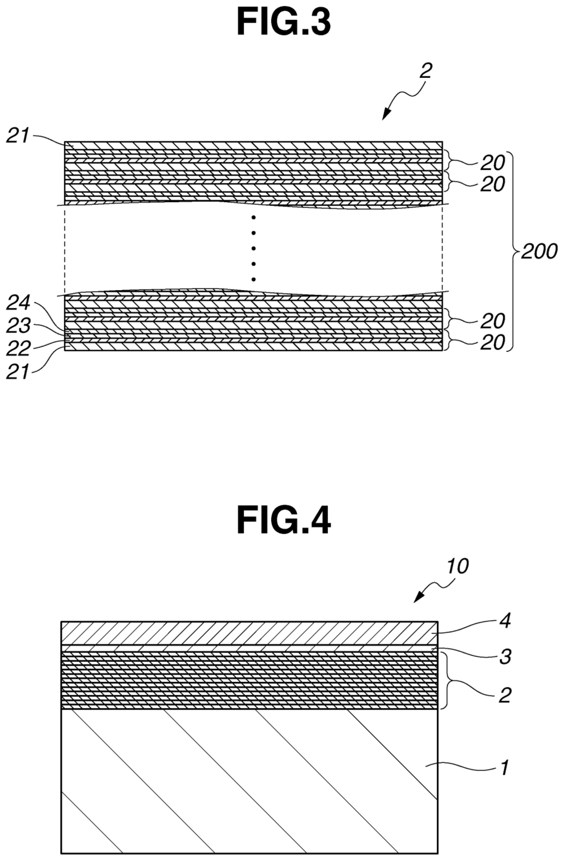

FIG. 3 is a cross-sectional view illustrating another example of a multilayer reflection film of the invention. This multilayer reflection film 2 include a periodically laminated structure 200 in which repeating units 20 consisting of, from the substrate side (bottom side in the figure), a high refractive index layer 21, an intermediate layer 22, a low refractive index layer 23, and a medium refractive index layer 24 are multiply stacked. At the side remote from the substrate of the periodically laminated structure 200 (the uppermost portion in the figure), a high refractive index layer 21, as a layer remotest from the substrate in the multilayer reflection film 2, is formed in contact with the periodically laminated structure 200.

The material constituting the high refractive index layer preferably has a refractive index of not less than 0.98 and not more than 1.02 with respect to EUV light (wavelength: 13.5 nm) which is exposure light. Examples of the materials include silicon (Si). The high refractive index layer preferably contains silicon (Si).

The high refractive index layer may further contain at least one light element selected from the group consisting of oxygen (O), nitrogen (N), carbon (C), boron (B) and hydrogen (H) as long as the high refractive index layer has a refractive index within a prescribed range. In addition, in the case that the multilayer reflection film includes the intermediate layer, among the light elements, the high refractive index layer is preferably free of the light element contained in the intermediate layer. Further, the high refractive index layer is preferably free of a metal and a metalloid contained in the material constituting the low refractive index layer and the material constituting the medium refractive index layer. Particularly, the high refractive index layer preferably consists of silicon (Si).

The high refractive index layer has a thickness of preferably not less than 2.5 nm, more preferably not less than 3 nm, and preferably not more than 5.5 nm, more preferably not more than 5 nm.

The material constituting the low refractive index layer preferably has a refractive index of not less than 0.87 and not more than 0.90 with respect to EUV light (wavelength: 13.5 nm) which is exposure light. Examples of the materials include ruthenium (Ru). The low refractive index layer preferably contains ruthenium (Ru).

The low refractive index layer may further contain at least one additive metal selected from the group consisting of molybdenum (Mo) and niobium (Nb) as long as the low refractive index layer has a refractive index within a prescribed range. The low refractive index layer may further contain at least one light element selected from the group consisting of oxygen (O), nitrogen (N), carbon (C), boron (B) and hydrogen (H) as long as the low refractive index layer has a refractive index within a prescribed range. Further, the low refractive index layer is preferably free of a metal and a metalloid contained in the material constituting the high refractive index layer. On the other hand, the low refractive index layer may contain a metal or a metalloid contained in the material constituting the medium refractive index layer, however, the low refractive index layer is preferably free of the metal and the metalloid contained in the material constituting the medium refractive index layer. Particularly, the low refractive index layer preferably consists of ruthenium (Ru), or preferably consists of ruthenium (Ru) and the additive metal (for example, RuMo, RuNb, or RuMoNb).

The low refractive index layer has a thickness of preferably not less than 0.5 nm, more preferably not less than 1 nm, and preferably not more than 4 nm, more preferably not more than 3.5 nm from the viewpoint of obtaining a high reflectance.

The material constituting the medium refractive index layer preferably has a refractive index of more than 0.90, particularly not less than 0.91, and less than 0.98, particularly not more than 0.97 with respect to EUV light (wavelength: 13.5 nm) which is exposure light. Examples of the materials include molybdenum (Mo), niobium (Nb), yttrium (Y) and zirconium (Zr). The medium refractive index layer contains preferably at least one selected from the group consisting of molybdenum (Mo), niobium (Nb), yttrium (Y) and zirconium (Zr), more preferably at least one selected from the group consisting of molybdenum (Mo), niobium (Nb) and zirconium (Zr).

The medium refractive index layer may further contain ruthenium (Ru) as an additive metal as long as the medium refractive index layer has a refractive index within a prescribed range. The medium refractive index layer may further contain at least one light element selected from the group consisting of oxygen (O), nitrogen (N), carbon (C), boron (B) and hydrogen (H) as long as the medium refractive index layer has a refractive index within a prescribed range. Further, the medium refractive index layer is preferably free of a metal and a metalloid contained in the material constituting the high refractive index layer. On the other hand, the medium refractive index layer may contain a metal or a metalloid contained in the material constituting the low refractive index layer, however, the medium refractive index layer is preferably free of the metal and the metalloid contained in the material constituting the low refractive index layer. Particularly, the medium refractive index layer preferably consists of at least one selected from the group consisting of molybdenum (Mo), niobium (Nb) and zirconium (Zr) (Mo, Nb, Zr, MoNb, MoZr, NbZr, MoNbZr), or preferably consists of at least one selected from the group consisting of molybdenum (Mo), niobium (Nb) and zirconium (Zr), and the additive metal (for example, MoRu, NbRu, ZrRu, MoNbRu, MoZrRu, NbZrRu, MoNbZrRu).

The medium refractive index layer has a thickness of preferably not less than 0.5 nm, more preferably not less than 1 nm, and preferably not more than 4 nm, more preferably not more than 3.5 nm from the viewpoint of obtaining a high reflectance.

The low refractive index layer and the medium refractive index layer have a total thickness of preferably not less than 1 nm, more preferably not less than 1.5 nm, and preferably not more than 4.5 nm, more preferably not more than 4 nm.

A material constituting the intermediate layer may be any material that can prevent formation of a layer (a reaction layer, an interdiffusion layer) which may be formed at the interface portion between respective layers of the high refractive index layer, the low refractive index layer, and medium refractive index layer of the multilayer reflection film during formation of the multilayer reflection film or by heat treatment after the formation of the multilayer reflection film. The material is preferably not a material that excessively reduce the reflectance of the multilayer reflection film.

The material constituting the intermediate layer is preferably carbon (C), or a material containing at least one selected from the group consisting of silicon (Si), molybdenum (Mo), niobium (Nb), zirconium (Zr), tantalum (Ta), tungsten (W), chromium (Cr), titanium (Ti), hafnium (Hf), aluminum (Al) and germanium (Ge), and this material more preferably contains at least one light element selected from the group consisting of nitrogen (N), carbon (C) and boron (B), particularly, either or both of nitrogen (N) and carbon (C). In particular, examples of the materials include silicon carbide (SiC), silicon nitride (SiN), molybdenum carbide (MoC), molybdenum nitride (MoN), niobium carbide (NbC), niobium nitride (NbN), zirconium carbide (ZrC), zirconium nitride (ZrN), tantalum carbide (TaC), tantalum nitride (TaN), tungsten carbide (WC), tungsten nitride (WN), chromium carbide (CrC), chromium nitride (CrN), titanium carbide (TiC), titanium nitride (TiN), hafnium carbide (HfC), hafnium nitride (HfN), aluminum carbide (AlC), aluminum nitride (AlN), germanium carbide (GeC), and germanium nitride (GeN). The intermediate layer preferably contains the material, particularly either or both of silicon nitride (SiN) and tantalum nitride (TaN). The intermediate layer more preferably consists of the material, particularly either or both of silicon nitride (SiN) and tantalum nitride (TaN).

The intermediate layer intervening between the high refractive index layer and the low refractive index layer is preferably composed of a material satisfying the above expression (3). In Particular, the material constituting the intermediate layer intervening between the high refractive index layer containing silicon (Si), particularly, consisting of silicon (Si), and the low refractive index layer containing ruthenium (Ru), particularly consisting of ruthenium (Ru) is preferably a material containing at least one selected from the group consisting of tantalum (Ta), tungsten (W), chromium (Cr), titanium (Ti), hafnium (Hf), aluminum (Al) and germanium (Ge), more preferably a material containing at least one selected from the group consisting of tantalum (Ta), tungsten (W), chromium (Cr), titanium (Ti), hafnium (Hf), aluminum (Al) and germanium (Ge), and either or both of nitrogen (N) and carbon (C). Further, a material containing silicon nitride (SiN) is also preferable.

The intermediate layer has a thickness of preferably not more than 1 nm, more preferably not more than 0.8 nm, even more preferably not more than 0.5 nm. The intermediate layer normally has a lower limit of the thickness of not less than 0.2 nm. Presence of the intermediate layer causes reduction of the reflectance of the multilayer reflection film. However, the presence of the intermediate layer prevents formation of a reaction layer or an interdiffusion layer formed between respective layers of the high refractive index layer, the low refractive index layer, and the medium refractive index layer of the multilayer reflection film, thus, a relatively high reflectance can be obtained. Accordingly, a high reflectance can be obtained by appropriately adjusting the thickness of the intermediate layer, the position at which the intermediate layer is provided, and the number of the intermediate layers.

Examples of methods for forming the multilayer reflection film include a sputtering method in which, to perform sputtering, power is supplied to a target, and plasma of an atmospheric gas is formed (an atmospheric gas is ionized) by the supplied power, and an ion beam sputtering method in which a target is irradiated with ion beam. The sputtering methods include a DC sputtering method in which a DC voltage is applied to a target, and an RF sputtering method in which a high frequency voltage is applied to a target. Particularly, a magnetron sputtering method, which utilizes a magnetic field to perform sputtering efficiently, has an advantage in productivity. The power may be applied to the target by a DC system or an RF system. The DC system includes also a pulse sputtering in which a negative bias applied to the target is inverted for a short time to prevent charge-up of the target.

The multilayer reflection film may be formed by, for example, a sputtering method using a sputtering apparatus to which a plurality of targets, particularly three or more of targets can be mounted. Particularly, for the reflective mask blank of the invention, the multilayer reflection film is preferably formed by sputtering using a sputtering apparatus in which three or more types of targets can be simultaneously mounted in a chamber, and sequentially discharging the three or more types of targets.

In particular, the multilayer reflection film may be formed with using, as targets, targets appropriately selected from the group consisting of metal targets and metalloid targets for forming the high refractive index layer, the intermediate layer, the low refractive index layer, and the medium refractive index layer, for example, a silicon (Si) target for forming a silicon (Si)-containing layer, a ruthenium (Ru) target for forming a ruthenium (Ru)-containing layer, a molybdenum (Mo) target for forming a molybdenum (Mo)-containing layer, a niobium (Nb) target for forming a niobium (Nb)-containing layer, a zirconium (Zr) target for forming a zirconium (Zr)-containing layer, a tantalum (Ta) target for forming a tantalum (Ta)-containing layer, and other targets, and with using, as a sputtering gas, a rare gas such as neon (Ne) gas, argon (Ar) gas, krypton (Kr) gas and xenon (Xe) gas.

Further, a layer containing a light element such as oxygen (O), nitrogen (N), carbon (C) and hydrogen (H) can be formed by reactive sputtering using a reactive gas such as an oxygen-containing gas, a nitrogen-containing gas, a carbon-containing gas, and a hydrogen-containing gas with the rare gas. Examples of the reactive gases include oxygen ($O_2$) gas, nitrogen ($N_2$) gas, hydrogen ($H_2$) gas, a nitrogen oxide gas such as nitrous oxide ($N_2O$) gas, nitrogen monoxide (NO) gas and nitrogen dioxide ($NO_2$) gas, a carbon oxide gas such as carbon monoxide (CO) gas and carbon dioxide ($CO_2$) gas, and a hydrogen carbon gas such as methane ($CH_4$) gas. For example, when a layer containing silicon nitride (SiN) is formed, the layer can be formed by reactive sputtering simultaneously using a nitrogen-containing gas such as nitrogen ($N_2$) and the rare gas.

Moreover, when a layer containing boron (B) is formed, a boron carbide ($B_4C$) target or a metal or metalloid target added with boron (B) can be used. Examples of the metal or metalloid targets added with boron (B) include a silicon (Si) target added with boron (B) (a silicon boride (SiB) target), a ruthenium (Ru) target added with boron (B) (a ruthenium boride (RuB) target), a molybdenum (Mo) target added with boron (B) (a molybdenum boride (MoB) target), a niobium (Nb) target added with boron (B) (a niobium boride (NbB) target), a zirconium (Zr) target added with boron (B) (a zirconium boride (ZrB) target), and a tantalum (Ta) target added with boron (B) (a tantalum boride (TaB) target).

A reflective mask blank generally includes an absorber film with a substrate and a multilayer reflection film. A protection film is normally formed between the multilayer reflection film and the absorber film. As such a reflective mask blank, in particular, a reflective mask blank including a substrate, a multilayer reflection film that is formed on one main surface of the substrate and reflects exposure light, a protection film that is formed on the multilayer reflection film, and an absorber film that is formed on the protection film and absorbs the exposure light is exemplified.

From a reflective mask blank including an absorber film, a reflective mask can be manufactured by patterning the absorber film to form an absorber pattern. From a reflective mask blank including a multilayer reflection film, a protection film and an absorber film, a reflective mask including the substrate, the multilayer reflection film that is formed on one main surface of the substrate and reflects exposure light, the protection film that is formed on the multilayer reflection film, and a pattern of the absorber film (an absorber pattern) that is formed on the protection film and absorbs the exposure light can be manufactured.

The reflective mask blank of the invention may include a protection film on the multilayer reflection film. The protection film is required to have functions of protecting the multilayer reflection film from various dry etching and cleaning in manufacturing process of a reflective mask, exposure environment when the reflection mask is used, or cleaning process in recycling process after use (resistances to various dry etching and cleaning in manufacturing process of a reflective mask, exposure environment when the reflection mask is used, or cleaning process in recycling process after use). The protection film may consist of multiple layers. The protection film may be formed on the multilayer reflection film with another film intervening therebetween, however is normally formed in contact with the multilayer reflection film.

Examples of materials of the protection film include a material containing ruthenium (Ru), particularly a material consisting of ruthenium (Ru), a material containing ruthenium (Ru) and at least one additive metal selected from the group consisting of niobium (Nb), zirconium (Zr), titanium (Ti) and rhodium (Rh), particularly a material consisting of ruthenium (Ru) and at least one additive metal selected from the group consisting of niobium (Nb), zirconium (Zr), titanium (Ti) and rhodium (Rh). The material of the protection film may further contain oxygen (O), nitrogen (N), carbon (C) or others. The protection film normally has a thickness of about 2 to 5 nm, however, not particularly limited thereto.

The protection film can be formed, for example, by a sputtering method. As a target, a ruthenium (Ru) target or a ruthenium (Ru) alloy target for forming a film containing ruthenium (Ru), or a niobium (Nb) target or a niobium (Nb) alloy target for forming a film containing niobium (Nb) may be used. In particular, a target appropriately selected from the group consisting a ruthenium (Ru) target, a niobium target (Nb), an alloy target of ruthenium (Ru) and niobium (Nb), and others may be used. The protection film can be formed by sputtering using, as a sputtering gas, a rare gas such as neon (Ne) gas, argon (Ar) gas, krypton (Kr) gas and xenon (Xe) gas, or by reactive sputtering using a reactive gas such as an oxygen-containing gas, a nitrogen-containing gas, and a carbon-containing gas with the rare gas.

The reflective mask blank of the invention may include an absorber film that absorbs exposure light (reduces reflectance) on the multilayer reflection film. The absorber film is a film that functions as a film for forming a pattern. The absorber film may be formed in contact with the multilayer reflection film, however is preferably formed with an intervening other film, usually with a protection film intervened therebetween.

FIG. 4 is a cross-sectional view illustrating another example of a reflective mask blank of the invention. This reflective mask 10 includes a substrate 1, and on the substrate 1, a multilayer reflection film 2 that is formed in contact with the substrate 1, a protection film 3 that is formed in contact with the multilayer reflection film 2, and an absorber film 4 that is formed in contact with the protection film 3.

The material of the absorber film may be a material that absorbs EUV light and can be processed to a pattern. As the material of the absorber film, for example, a material containing tantalum (Ta) or chromium (Cr) is exemplified, however, not particularly limited thereto. The material containing Ta or Cr may contain oxygen (O), nitrogen (N), carbon (C), boron (B) or others. Examples of the materials containing Ta include simple substance of Ta, and a tantalum compound such as TaO, TaN, TaON, TaC, TaCO, TaCN, TaCON, TaB, TaOB, TaNB, TaONB, TaCB, TaCOB, TaCNB, and TaCONB.

Examples of materials containing Cr include simple substance of Cr, and a chromium compound such as CrO, CrN, CrON, CrC, CrCO, CrCN, CrCON, CrB, CrOB, CrNB, CrONB, CrCB, CrCOB, CrCNB, and CrCONB. The absorber film normally has a thickness of about 40 to 80 nm, however, not particularly limited thereto.

The absorber film can be formed by sputtering, and the sputtering is preferably magnetron sputtering. In particular, the absorber film may be formed by sputtering using a metal target such as a chromium (Cr) target and a tantalum (Ta) target, or a metal compound target such as a chromium compound target and a tantalum compound target (a target containing a metal such as Cr and Ta, and oxygen (O), nitrogen (N), carbon (C) and/or boron (B)), and using, as a sputtering gas, a rare gas such as neon (Ne) gas, argon (Ar) gas, krypton (Kr) gas and xenon (Xe) gas, or by reactive sputtering using a reactive gas such as an oxygen-containing gas, a nitrogen-containing gas, and a carbon-containing gas with the rare gas. Further, when a film containing boron (B) is formed, a chromium (Cr) target added with boron (B) (a chromium boride (CrB) target), or a tantalum (Ta) target added with boron (B) (a tantalum boride (TaB) target) may be used.

A hard mask film (an etching mask film for the absorber film) having etching properties that is different from those of the absorber film may be formed on the side remote from the substrate of the absorber film, preferably in contact with the absorber film. This hard mask film is a film that functions as an etching mask when the absorber film is dry-etched. After forming the absorber pattern, the hard mask film may be left, for example, as a part of the absorber film to utilize as a reflectance reduction layer for reducing reflectance at a wavelength of light used in an inspection such as a pattern inspection, or may be removed so that it does not remain on the reflective mask. Examples of the materials of the hard mask film include a material containing chromium (Cr). The hard mask film composed of a material containing Cr is particularly suitable when the absorber film is composed of a material containing Ta and being free of Cr. When a layer that mainly assumes function of reducing reflectance at a wavelength of light used in an inspection such as a pattern inspection (a reflectance reduction layer) is formed on the absorber film, the hard mask film may be formed on the reflectance reduction layer on the absorber film. The hard mask film can be formed, for example, by a magnetron sputtering method. The hard mask film normally has a thickness of about 5 to 20 nm, however, not particularly limited thereto.

A conducting film used for electrostatic chucking a reflective mask to an exposure apparatus may be formed in the reflective mask blank on the other main surface (back side surface) which is the opposite surface to the one main surface of the substrate, preferably in contact with the other main surface.

The conducting film preferably has a sheet resistance of not more than 100 Ω/square. Examples of materials of the conducting film include, for example, a material containing tantalum (Ta) or chromium (Cr), however, not particularly limited thereto. The material containing tantalum (Ta) or chromium (Cr) may contain oxygen (O), nitrogen (N), carbon (C), boron (B) or others. Examples of the materials containing tantalum (Ta) include simple substance of Ta, and a tantalum (Ta) compound such as TaO, TaN, TaON, TaC, TaCO, TaCN, TaCON, TaB, TaOB, TaNB, TaONB, TaCB, TaCOB, TaCNB and TaCONB. Examples of the materials containing chromium (Cr) include simple substance of Cr, and a chromium (Cr) compound such as CrO, CrN, CrON, CrC, CrCO, CrCN, CrCON CrB, CrOB, CrNB, CrONB, CrCB, CrCOB, CrCNB and CrCONB.

The conducting film has a thickness of generally about 20 to 300 nm, however, not particularly limited thereto as long as the thickness is enough to function for electrostatic chucking use. The conducting film is preferably formed so as to have a thickness at which film stresses between the conducting film, and the film(s) and the pattern of the film formed at the side of the front main surface such as the multilayer reflection film, the protection film, and the pattern of the absorber film (absorber pattern) are balanced after processing to the reflective mask, particularly, after forming the pattern of the absorber film (absorber pattern).

The conducting film may be formed before forming the multilayer reflection film, or after forming all of the films on the substrate at the multilayer reflection film side. After forming a part of the films on the substrate at the multilayer reflection film side, the conducting film may be formed, and then the remainder of the films at the multilayer reflection film side may be formed on the substrate.

The conducting film can be formed by sputtering, and the sputtering is preferably magnetron sputtering. In particular, the conducting film may be formed by sputtering using a metal target such as a chromium (Cr) target and a tantalum (Ta) target, or a metal compound target such as a chromium compound target and a tantalum compound target (a target containing a metal such as Cr and Ta, and oxygen (O), nitrogen (N), carbon (C) and/or boron (B)), and using, as a sputtering gas, a rare gas such as neon (Ne) gas, argon (Ar) gas, krypton (Kr) gas and xenon (Xe) gas, or by reactive sputtering using a reactive gas such as an oxygen-containing gas, a nitrogen-containing gas, and a carbon-containing gas with the rare gas. Further, when a film containing boron (B) is formed, a chromium (Cr) target added with boron (B) (a chromium boride (CrB) target), or a tantalum (Ta) target added with boron (B) (a tantalum boride (TaB) target) may be used.

The reflective mask blank may further include a resist film formed on the side remotest from the substrate. The resist film is preferably an electron beam (EB) resist.

EXAMPLES

Examples of the invention are given below by way of illustration and not by way of limitation.

Examples 1 to 4

A low thermal expansion glass substrate (SiO$_2$-TiO$_2$-based glass substrate) having dimensions of 152 mm-square and 6.35 mm-thick was used as a substrate. A sputtering apparatus that can mount a plurality of targets and can discharge targets one by one or multiple targets simultaneously was used to form a multilayer reflection film by DC magnetron sputtering with arranging the targets facing to the main surface of the substrate, while rotating the substrate.

A silicon (Si) target, a ruthenium (Ru) target and a molybdenum (Mo) target were mounted in a chamber of the sputtering apparatus, and the substrate was placed in the chamber. First, as a high refractive index layer, a silicon (Si) layer having a thickness of 4 nm was formed by applying an electric power to the silicon (Si) target while feeding argon (Ar) gas (flow rate: 12 SCCM) into the chamber, then the application of the electric power to the silicon (Si) target was terminated.

Next, as an intermediate layer, a silicon nitride (SiN) layer having a thickness of 0.5 nm was formed by applying an electric power to the silicon (Si) target while feeding argon (Ar) gas (flow rate: 15 SCCM) and nitrogen (N$_2$) gas (flow rate: 50 SCCM) into the chamber, then the application of the electric power to the silicon (Si) target was terminated.

Next, as a low refractive index layer, a ruthenium (Ru) layer was formed by applying an electric power to the ruthenium (Ru) target while feeding argon (Ar) gas (flow rate: 15 SCCM) into the chamber, then the application of the electric power to the ruthenium (Ru) target was terminated. The thicknesses of the low refractive index layers were 2 nm in Example 1, 1.5 nm in Example 2, 1 nm in Example 3, and 0.5 nm in Example 4.

Next, as a medium refractive index layer, a molybdenum (Mo) layer was formed by applying an electric power to the molybdenum (Mo) target while feeding argon (Ar) gas (flow rate: 30 SCCM) into the chamber, then the application of the electric power to the molybdenum (Mo) target was terminated. The thicknesses of the medium refractive index layers were 0.5 nm in Example 1, 1 nm in Example 2, 1.5 nm in Example 3, and 2 nm in Example 4.

The procedure for forming the high refractive index layer, the intermediate layer, the low refractive index layer, and the medium refractive index layer constituted as one cycle was repeated to form a periodically laminated structure. The repeat count was 30 cycles. After forming the medium refractive index layer in the 30th cycle, finally, a high refractive index layer of a silicon (Si) layer having a thickness of 4.5 nm, as an uppermost layer of the multilayer reflection film, was formed by the above manner to obtain the multilayer reflection film.

At a wavelength of 13.5 nm of EUV light which is exposure light, the refractive index $n_H$ and the extinction coefficient $k_H$ of silicon (Si) constituting the high refractive index layer were 0.999 and 0.0018, respectively, the refractive index $n_I$ and the extinction coefficient $k_I$ of silicon nitride (SiN) constituting the intermediate layer were 0.973 and 0.0093, respectively, the refractive index $n_L$ and the extinction coefficient $k_L$ of ruthenium (Ru) constituting the low refractive index layer were 0.886 and 0.017, respectively, and the refractive index $n_M$ and the extinction coefficient $k_M$ of molybdenum (Mo) constituting the medium refractive index layer were 0.923 and 0.0065, respectively.

Accordingly, each of the formed multilayer reflection films in Examples 1 to 4 satisfied the following expressions (1), (2) and (3):

$$k_H < k_L \qquad\qquad (1),$$

$$k_M < ((k_H - k_L)/(n_H - n_L)) \times (n_M - n_L) + k_L \qquad\qquad (2),$$

and

$$k_I > ((k_H - k_L)/(n_H - n_L)) \times (n_I - n_L) + k_L \qquad\qquad (3).$$

Reflectance of each of the obtained multilayer reflection films to EUV light having a wavelength of 13.1 to 14 nm was measured at an incident angle of 6 degrees. The reflectance was maximized at 13.5 nm in each, and the values were 65.0% in Example 1, 66.1% in Example 2, 67.1% in Example 3, and 65.7% in Example 4.

Example 5

A low thermal expansion glass substrate (SiO$_2$-TiO$_2$-based glass substrate) having dimensions of 152 mm-square and 6.35 mm-thick was used as a substrate. A sputtering apparatus that can mount a plurality of targets and can discharge targets one by one or multiple targets simultaneously was used to form a multilayer reflection film by DC magnetron sputtering with arranging the targets facing to the main surface of the substrate, while rotating the substrate.

A silicon (Si) target, a ruthenium (Ru) target and a molybdenum (Mo) target were mounted in a chamber of the sputtering apparatus, and the substrate was placed in the chamber. First, as a high refractive index layer, a silicon (Si) layer having a thickness of 4.5 nm was formed by applying an electric power to the silicon (Si) target while feeding argon (Ar) gas (flow rate: 12 SCCM) into the chamber, then the application of the electric power to the silicon (Si) target was terminated. In this example, no intermediate layer was formed.

Next, as a low refractive index layer having a thickness of 1 nm, which was the same in Example 3, a ruthenium (Ru) layer was formed by applying an electric power to the ruthenium (Ru) target while feeding argon (Ar) gas (flow rate: 15 SCCM) into the chamber, then the application of the electric power to the ruthenium (Ru) target was terminated.

Next, as a medium refractive index layer having a thickness of 1.5 nm, which was the same in Example 3, a molybdenum (Mo) layer was formed by applying an electric power to the molybdenum (Mo) target while feeding argon (Ar) gas (flow rate: 30 SCCM) into the chamber, then the application of the electric power to the molybdenum (Mo) target was terminated.

The procedure for forming the high refractive index layer, the low refractive index layer, and the medium refractive index layer constituted as one cycle was repeated to form a periodically laminated structure. The repeat count was 30 cycles. After forming the medium refractive index layer in the 30th cycle, finally, a high refractive index layer of a silicon (Si) layer having a thickness of 4.5 nm, as an uppermost layer of the multilayer reflection film, was formed by the above manner to obtain the multilayer reflection film.

At a wavelength of 13.5 nm of EUV light which is exposure light, the refractive index $n_H$ and the extinction coefficient $k_H$ of silicon (Si) constituting the high refractive index layer were 0.999 and 0.0018, respectively, the refractive index $n_L$ and the extinction coefficient $k_L$ of ruthenium (Ru) constituting the low refractive index layer were 0.886 and 0.017, respectively, and the refractive index $n_M$ and the extinction coefficient $k_M$ of molybdenum (Mo) constituting the medium refractive index layer were 0.923 and 0.0065, respectively. Accordingly, the formed multilayer reflection film in Example 5 satisfied the above expressions (1) and (2).

Reflectance of the obtained multilayer reflection film to EUV light having a wavelength of 13.1 to 14 nm was measured at an incident angle of 6 degrees. The reflectance was maximized at 13.5 nm, and the value was 64.2%.

Examples 6 to 8

A low thermal expansion glass substrate ($SiO_2$-$TiO_2$-based glass substrate) having dimensions of 152 mm-square and 6.35 mm-thick was used as a substrate. A sputtering apparatus that can mount a plurality of targets and can discharge targets one by one or multiple targets simultaneously was used to form a multilayer reflection film by DC magnetron sputtering with arranging the targets facing to the main surface of the substrate, while rotating the substrate.

A silicon (Si) target, a ruthenium (Ru) target and a niobium (Nb) target were mounted in a chamber of the sputtering apparatus, and the substrate was placed in the chamber. First, as a high refractive index layer, a silicon (Si) layer having a thickness of 4 nm was formed by applying an electric power to the silicon (Si) target while feeding argon (Ar) gas (flow rate: 12 SCCM) into the chamber, then the application of the electric power to the silicon (Si) target was terminated.

Next, as an intermediate layer, a silicon nitride (SiN) layer having a thickness of 0.5 nm was formed by applying an electric power to the silicon (Si) target while feeding argon (Ar) gas (flow rate: 15 SCCM) and nitrogen ($N_2$) gas (flow rate: 50 SCCM) into the chamber, then the application of the electric power to the silicon (Si) target was terminated.

Next, as a low refractive index layer, a ruthenium (Ru) layer was formed by applying an electric power to the ruthenium (Ru) target while feeding argon (Ar) gas (flow rate: 15 SCCM) into the chamber, then the application of the electric power to the ruthenium (Ru) target was terminated. The thicknesses of the low refractive index layers were 2 nm in Example 6, 1.5 nm in Example 7, and 1 nm in Example 8.

Next, as a medium refractive index layer, a niobium (Nb) layer was formed by applying an electric power to the niobium (Nb) target while feeding argon (Ar) gas (flow rate: 30 SCCM) into the chamber, then the application of the electric power to the niobium (Nb) target was terminated. The thicknesses of the medium refractive index layers were 0.5 nm in Example 6, 1 nm in Example 7, and 1.5 nm in Example 8.

The procedure for forming the high refractive index layer, the intermediate layer, the low refractive index layer, and the medium refractive index layer constituted as one cycle was repeated to form a periodically laminated structure. The repeat count was 30 cycles. After forming the medium refractive index layer in the 30th cycle, finally, a high refractive index layer of a silicon (Si) layer having a thickness of 4.5 nm, as an uppermost layer of the multilayer reflection film, was formed by the above manner to obtain the multilayer reflection film.

At a wavelength of 13.5 nm of EUV light which is exposure light, the refractive index $n_H$ and the extinction coefficient $k_H$ of silicon (Si) constituting the high refractive index layer were 0.999 and 0.0018, respectively, the refractive index $n_I$ and the extinction coefficient $k_I$ of silicon nitride (SiN) constituting the intermediate layer were 0.973 and 0.0093, respectively, the refractive index $n_L$ and the extinction coefficient $k_L$ of ruthenium (Ru) constituting the low refractive index layer were 0.886 and 0.017, respectively, and the refractive index $n_M$ and the extinction coefficient $k_M$ of niobium (Nb) constituting the medium refractive index layer were 0.934 and 0.0052, respectively. Accordingly, each of the formed multilayer reflection films in Examples 6 to 8 satisfied the above expressions (1), (2) and (3).

Reflectance of each of the obtained multilayer reflection films to EUV light having a wavelength of 13.1 to 14 nm was measured at an incident angle of 6 degrees. The reflectance was maximized at 13.5 nm in each, and the values were 65.3% in Example 6, 66.7% in Example 7, and 65.1% in Example 8.

Comparative Example 1

A reflective mask blank was obtained by forming a multilayer reflection film in the same manner in Example 1 except that a silicon (Si) layer having a thickness of 4.5 nm as the high refractive index layer, and a ruthenium (Ru) layer having a thickness of 2.5 nm as the low refractive index layer were formed, and the intermediate layer and the medium refractive index layer ware not formed.

Reflectance of the obtained multilayer reflection film to EUV light having a wavelength of 13.1 to 14 nm was measured at an incident angle of 6 degrees. The reflectance was maximized at 13.5 nm, and the value was 56.5%.

By comparing Examples 1 to 8 with Comparative Example 1, it was confirmed that a high reflectance can be obtained by a multilayer reflection film having a periodically laminated structure in which repeating units including one each of a high refractive index layer, a low refractive index layer, and a medium refractive index layer were multiply stacked.

Comparative Examples 2 and 3

In Comparative Examples 2 and 3, reflective mask blanks were obtained by forming multilayer reflection films in the same manner in Examples 3 and 7, respectively, except that the order of the formation of the low refractive index layer, and the formation of the medium refractive index layer were reversed.

Reflectance of each of the obtained multilayer reflection films to EUV light having a wavelength of 13.1 to 14 nm was measured at an incident angle of 6 degrees. The reflectance was maximized at 13.5 nm in each, and the values were 59.9% in Comparative Example 2, and 58.7% in Comparative Example 3.

By comparing Example 3 with Comparative Example 2, or by comparing Example 7 with Comparative Example 3, it was confirmed that a high reflectance can be obtained by a multilayer reflection film having a periodically laminated structure in which a high refractive index layer, an intermediate layer, a low refractive index layer, and a medium refractive index layer of a repeating unit were arranged in this order from the substrate side.

Example 9

A low thermal expansion glass substrate ($SiO_2$-$TiO_2$-based glass substrate) having dimensions of 152 mm-square and 6.35 mm-thick was used as a substrate. A sputtering apparatus that can mount a plurality of targets and can discharge targets one by one or multiple targets simultaneously was used to form a multilayer reflection film by DC magnetron sputtering with arranging the targets facing to the main surface of the substrate, while rotating the substrate.

A silicon (Si) target, a ruthenium (Ru) target and a zirconium (Zr) target were mounted in a chamber of the sputtering apparatus, and the substrate was placed in the chamber. First, as a high refractive index layer, a silicon (Si) layer having a thickness of 4 nm was formed by applying an electric power to the silicon (Si) target while feeding argon (Ar) gas (flow rate: 12 SCCM) into the chamber, then the application of the electric power to the silicon (Si) target was terminated.

Next, as an intermediate layer, a silicon nitride (SiN) layer having a thickness of 0.5 nm was formed by applying an electric power to the silicon (Si) target while feeding argon (Ar) gas (flow rate: 15 SCCM) and nitrogen ($N_2$) gas (flow rate: 50 SCCM) into the chamber, then the application of the electric power to the silicon (Si) target was terminated.

Next, as a low refractive index layer, a ruthenium (Ru) layer having a thickness of 2 nm was formed by applying an electric power to the ruthenium (Ru) target while feeding argon (Ar) gas (flow rate: 15 SCCM) into the chamber, then the application of the electric power to the ruthenium (Ru) target was terminated.

Next, as a medium refractive index layer, a zirconium (Zr) layer having a thickness of 0.5 nm was formed by applying an electric power to the zirconium (Zr) target while feeding argon (Ar) gas (flow rate: 30 SCCM) into the chamber, then the application of the electric power to the zirconium (Zr) target was terminated.

The procedure for forming the high refractive index layer, the intermediate layer, the low refractive index layer, and the medium refractive index layer constituted as one cycle was repeated to form a periodically laminated structure. The repeat count was 30 cycles. After forming the medium refractive index layer in the 30th cycle, finally, a high refractive index layer of a silicon (Si) layer having a thickness of 4.5 nm, as an uppermost layer of the multilayer reflection film, was formed by the above manner to obtain the multilayer reflection film.

At a wavelength of 13.5 nm of EUV light which is exposure light, the refractive index $n_H$ and the extinction coefficient $k_H$ of silicon (Si) constituting the high refractive index layer were 0.999 and 0.0018, respectively, the refractive index $n_I$ and the extinction coefficient $k_I$ of silicon nitride (SiN) constituting the intermediate layer were 0.973 and 0.0093, respectively, the refractive index $n_L$ and the extinction coefficient $k_L$ of ruthenium (Ru) constituting the low refractive index layer were 0.886 and 0.017, respectively, and the refractive index $n_M$ and the extinction coefficient $k_M$ of zirconium (Zr) constituting the medium refractive index layer were 0.959 and 0.0038, respectively. Accordingly, the formed multilayer reflection film satisfied the above expressions (1), (2) and (3).

Reflectance of the obtained multilayer reflection film to EUV light having a wavelength of 13.1 to 14 nm was measured at an incident angle of 6 degrees. The reflectance was maximized at 13.5 nm, and the value was 65.5%.

Example 10

A low thermal expansion glass substrate ($SiO_2$-$TiO_2$-based glass substrate) having dimensions of 152 mm-square and 6.35 mm-thick was used as a substrate. A sputtering apparatus that can mount a plurality of targets and can discharge targets one by one or multiple targets simultaneously was used to form a multilayer reflection film by DC magnetron sputtering with arranging the targets facing to the main surface of the substrate, while rotating the substrate.

A silicon (Si) target, a ruthenium (Ru) target, a molybdenum (Mo) target and a tantalum (Ta) target were mounted in a chamber of the sputtering apparatus, and the substrate was placed in the chamber. First, as a high refractive index layer, a silicon (Si) layer having a thickness of 4 nm was formed by applying an electric power to the silicon (Si) target while feeding argon (Ar) gas (flow rate: 12 SCCM) into the chamber, then the application of the electric power to the silicon (Si) target was terminated.

Next, as an intermediate layer, a tantalum nitride (TaN) layer having a thickness of 0.5 nm was formed by applying an electric power to the tantalum (Ta) target while feeding argon (Ar) gas (flow rate: 15 SCCM) and nitrogen ($N_2$) gas (flow rate: 50 SCCM) into the chamber, then the application of the electric power to the tantalum (Ta) target was terminated.

Next, as a low refractive index layer, a ruthenium (Ru) layer having a thickness of 1.5 nm was formed by applying an electric power to the ruthenium (Ru) target while feeding argon (Ar) gas (flow rate: 15 SCCM) into the chamber, then the application of the electric power to the ruthenium (Ru) target was terminated.

Next, as a medium refractive index layer, a molybdenum (Mo) layer having a thickness of 1 nm was formed by applying an electric power to the molybdenum (Mo) target while feeding argon (Ar) gas (flow rate: 30 SCCM) into the chamber, then the application of the electric power to the molybdenum (Mo) target was terminated.

The procedure for forming the high refractive index layer, the intermediate layer, the low refractive index layer, and the medium refractive index layer constituted as one cycle was repeated to form a periodically laminated structure. The repeat count was 30 cycles. After forming the medium refractive index layer in the 30th cycle, finally, a high refractive index layer of a silicon (Si) layer having a thickness of 4.5 nm, as an uppermost layer of the multilayer reflection film, was formed by the above manner to obtain the multilayer reflection film.

At a wavelength of 13.5 nm of EUV light which is exposure light, the refractive index $n_H$ and the extinction coefficient $k_H$ of silicon (Si) constituting the high refractive index layer were 0.999 and 0.0018, respectively, the refractive index $n_I$ and the extinction coefficient $k_I$ of tantalum nitride (TaN) constituting the intermediate layer were 0.950 and 0.029, respectively, the refractive index $n_L$ and the extinction coefficient $k_L$ of ruthenium (Ru) constituting the low refractive index layer were 0.886 and 0.017, respectively, and the refractive index $n_M$ and the extinction coefficient $k_M$ of molybdenum (Mo) constituting the medium refractive index layer were 0.923 and 0.0065, respectively. Accordingly, the formed multilayer reflection film satisfied the above expressions (1), (2) and (3).

Reflectance of the obtained multilayer reflection film to EUV light having a wavelength of 13.1 to 14 nm was measured at an incident angle of 6 degrees. The reflectance was maximized at 13.5 nm, and the value was 66.4%. The following statements set out further aspects of the present invention.

1. A reflective mask blank comprising a substrate, a multilayer reflection film that is formed on one main surface of the substrate and reflects exposure light, wherein

the multilayer reflection film has a periodically laminated structure in which repeating units are multiply stacked, the repeating unit comprises one each of a high refractive index layer, a low refractive index layer, and a medium refractive index layer having a refractive index lower than a refractive index of the high refractive index layer and higher than a refractive index of the low refractive index layer, and in the repeating unit, the high refractive index layer and the medium refractive index layer are disposed at the substrate side and the side remote from the substrate, respectively, with respect to the low refractive index layer.

2. The reflective mask blank of clause 1 wherein, with respect to a wavelength of the exposure light, the high refractive index layer, the low refractive index layer, and the medium refractive index layer in the repeating unit satisfy all of the following expressions (1) and (2):

$$k_H < k_L \qquad\qquad (1),$$

and

$$k_M < ((k_H-k_L)/(n_H-n_L)) \times (n_M-n_L)+k_L \qquad (2),$$

wherein $n_H$, $n_L$ and $n_M$ represent refractive indexes of the high refractive index layer, the low refractive index layer, and the medium refractive index layer, respectively, and $k_H$, $k_L$ and $k_M$ represent extinction coefficients of the high refractive index layer, the low refractive index layer, and the medium refractive index layer, respectively.

3. The reflective mask blank of clause 1 or 2 wherein the high refractive index layer comprises silicon (Si), the low refractive index layer comprises ruthenium (Ru), and the medium refractive index layer comprises at least one selected from the group consisting of molybdenum (Mo), niobium (Nb) and zirconium (Zr).

4. The reflective mask blank of any one of clauses 1 to 3 wherein the multilayer reflection film comprises an intermediate layer at one or more positions selected from the group consisting of a position intervening between the high refractive index layer and the low refractive index layer, a position intervening between the low refractive index layer and the medium refractive index layer, and a position intervening between the medium refractive index layer and the high refractive index layer.

5. The reflective mask blank of clause 4 wherein the multilayer reflection film comprises the intermediate layer intervening between the high refractive index layer and the low refractive index layer.

6. The reflective mask blank of clause 5 wherein, with respect to a wavelength of the exposure light, the high refractive index layer, the intermediate layer intervening between the high refractive index layer and the low refractive index layer, the low refractive index layer, and the medium refractive index layer in the repeating unit satisfy all of the following expressions (1), (2) and (3):

$$k_H < k_L \qquad (1),$$

$$k_M < ((k_H-k_L)/(n_H-n_L)) \times (n_M-n_L)+k_L \qquad (2),$$

and

$$k_I > ((k_H-k_L)/(n_H-n_L)) \times (n_I-n_L)+k_L \qquad (3),$$

wherein $n_H$, $n_I$, $n_L$ and $n_M$ represent refractive indexes of the high refractive index layer, the intermediate layer intervening between the high refractive index layer and the low refractive index layer, the low refractive index layer, and the medium refractive index layer, respectively, and $k_H$, $k_I$, $k_L$ and $k_M$ represent extinction coefficients of the high refractive index layer, the intermediate layer intervening between the high refractive index layer and the low refractive index layer, the low refractive index layer, and the medium refractive index layer, respectively.

7. The reflective mask blank of clause 5 or 6 wherein the repeating unit consists of one each of the high refractive index layer, the intermediate layer, the low refractive index layer, and the medium refractive index layer, and in the repeating unit, the high refractive index layer, the intermediate layer, the low refractive index layer, and the medium refractive index layer are arranged in this order from the substrate side.

8. The reflective mask blank of any one of clauses 4 to 7 wherein the high refractive index layer comprises silicon (Si), the intermediate layer comprises either or both of silicon nitride (SiN) and tantalum nitride (TaN), the low refractive index layer comprises ruthenium (Ru), and the medium refractive index layer comprises at least one selected from the group consisting of molybdenum (Mo), niobium (Nb) and zirconium (Zr).

9. The reflective mask blank of any one of clauses 4 to 7 wherein the high refractive index layer consists of silicon (Si), the intermediate layer consists of either or both of silicon nitride (SiN) and tantalum nitride (TaN), the low refractive index layer consists of ruthenium (Ru), and the medium refractive index layer consists of at least one selected from the group consisting of molybdenum (Mo), niobium (Nb) and zirconium (Zr).

10. The reflective mask blank of any one of clauses 4 to 9 wherein the high refractive index layer has a thickness of not less than 2.5 nm and not more than 5.5 nm, the intermediate layer has a thickness of not less than 0.2 nm and not more than 1 nm, the low refractive index layer has a thickness of not less than 0.5 nm and not more than 4 nm, and the medium refractive index layer has a thickness of not less than 0.5 nm and not more than 4 nm.

11. The reflective mask blank of any one of clauses 1 to 10 wherein the multilayer reflection film consists of the periodically laminated structure, and another high refractive index layer disposed at the side remotest from the substrate.

12. A manufacturing method of the reflective mask blank of any one of clauses 1 to 11, comprising the step of forming the multilayer reflection film by sputtering using a sputtering apparatus on which three or more types of targets can be simultaneously mounted in its chamber, and sequentially discharging the three or more types of targets.

**Claims**

1. A reflective mask blank (10) comprising a substrate (1), a multilayer reflection film (2) that is formed on one main surface of the substrate (1) and reflects exposure light,

wherein the multilayer reflection film (2) has a periodically laminated structure (200) in which repeating units (20) are multiply stacked,
the repeating unit (20) comprises one each of a high refractive index layer (21), a low refractive index layer (23), and a medium refractive index layer (24) having a refractive index lower than a refractive index of the high refractive index layer (21) and higher than a refractive index of the low refractive index layer (23),and in the repeating unit (20), the high refractive index layer (21) and the medium refractive index layer (24) are disposed at the substrate side and the side remote from the substrate (1), respectively, with respect to the low refractive index layer,
wherein the multilayer reflection film (2) comprises an intermediate layer (22) at one or more positions selected from a position intervening between the high refractive index layer (21) and the low refractive index layer (23), a position intervening between the low refractive index layer (23) and the medium refractive index layer (24), and a position intervening between the medium refractive index layer (24) and the high refractive index layer (21), and wherein the high refractive index layer (21) comprises silicon, the intermediate layer (22) comprises a material comprising at least one selected from chromium and germanium, the low refractive index layer (23) comprises ruthenium and the medium refractive index layer (24) comprises at least one selected from molybdenum, niobium and zirconium.

2. The reflective mask blank of claim 1 wherein, with respect to a wavelength of the exposure light, the high refractive index layer (21), the low refractive index layer (23), and the medium refractive index layer (24) in the repeating unit (20) satisfy all of the following expressions (1) and (2):

$$k_H < k_L \qquad\qquad (1),$$

and

$$k_M < ((k_H - k_L)/(n_H - n_L)) \times (n_M - n_L) + k_L \qquad (2),$$

wherein $n_H$, $n_L$ and $n_M$ represent refractive indexes of the high refractive index layer, the low refractive index layer, and the medium refractive index layer, respectively, and $k_H$, $k_L$ and $k_M$ represent extinction coefficients of the high refractive index layer, the low refractive index layer, and the medium refractive index layer, respectively.

3. The reflective mask blank of claim 1 or 2 wherein the multilayer reflection film (2) comprises the intermediate layer (22) intervening between the high refractive index layer (21) and the low refractive index layer (23).

4. The reflective mask blank of claim 3 wherein, with respect to a wavelength of the exposure light, the high refractive index layer (21), the intermediate layer (22) intervening between the high refractive index layer (21) and the low refractive index layer (23), the low refractive index layer (23), and the medium refractive index layer (24) in the repeating unit (20) satisfy all of the following expressions (1), (2) and (3):

$$k_H < k_L \qquad\qquad (1),$$

$$k_M < ((k_H - k_L)/(n_H - n_L)) \times (n_M - n_L) + k_L \qquad (2),$$

and

$$k_I > ((k_H - k_L)/(n_H - n_L)) \times (n_I - n_L) + k_L \qquad (3),$$

wherein $n_H$, $n_I$, $n_L$ and $n_M$ represent refractive indexes of the high refractive index layer, the intermediate layer intervening between the high refractive index layer and the low refractive index layer, the low refractive index layer, and the medium refractive index layer, respectively, and $k_H$, $k_I$, $k_L$ and $k_M$ represent extinction coefficients of the high refractive index layer, the intermediate layer intervening between the high refractive index layer and the low refractive index layer, the low refractive index layer, and the medium refractive index layer, respectively.

5. The reflective mask blank of claim 3 or 4 wherein the repeating unit (20) consists of one each of the high refractive index layer (21), the intermediate layer (22), the low refractive index layer (23), and the medium refractive index layer (24), and in the repeating unit, the high refractive index layer, the intermediate layer, the low refractive index layer, and the medium refractive index layer are arranged in this order from the substrate side.

6. The reflective mask blank of any one of claims 1 to 5 wherein the high refractive index layer (21) consists of silicon, the intermediate layer (22) consists of a material comprising at least one selected from chromium and germanium, the low refractive index layer (23) consists of ruthenium, and the medium refractive index layer (24) consists of at least one selected from molybdenum, niobium and zirconium.

7. The reflective mask blank of any one of claims 1 to 6 wherein the high refractive index layer (21) has a thickness of not less than 2.5 nm and not more than 5.5 nm, the intermediate layer (22) has a thickness of not less than 0.2 nm and not more than 1 nm, the low refractive index layer (23) has a thickness of not less than 0.5 nm and not more than 4 nm, and the medium refractive index layer (24) has a thickness of not less than 0.5 nm and not more than 4 nm.

8. The reflective mask blank of any one of claims 1 to 7 wherein the multilayer reflection film (2) consists of the periodically laminated structure, and another high refractive index layer (21) disposed at the side remotest from the substrate.

9. The reflective mask blank of any one of claims 1 to 8 wherein the material comprises at least one light element selected from nitrogen and carbon.

10. The reflective mask blank of claim 9 wherein the material is at least one selected from chromium nitride and germanium nitride.

11. A manufacturing method of the reflective mask blank of any one of claims 1 to 10, comprising the step of forming the multilayer reflection film (2) by sputtering using a sputtering apparatus on which three or more types of targets can be simultaneously mounted in its chamber, and sequentially discharging the three or more types of targets.

# FIG.1

# FIG.2

# FIG.3

# FIG.4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007109971 A